# EUROPEAN PATENT SPECIFICATION

(11) **EP 0 839 322 B1**
(45) Date of publication and mention of the grant of the patent: **10.08.2005**
(21) Application number: 97926534.5
(22) Date of filing: 15.05.1997
(51) Int. Cl.: G01R 1/067, G01R 1/073

(54) **MICROELECTRONIC CONTACT STRUCTURE AND METHOD OF MAKING SAME**
MIKROELEKTRONISCHE KONTAKTSTRUKTUR UND HERSTELLUNGSVERFAHREN DAZU
STRUCTURE DE CONTACT MICROELECTRONIQUE ET PROCEDE DE FABRICATION

(30) Priority: 17.05.1996 US 5189 P; 24.05.1996 WO PCT/US96/08107; 27.06.1996 US 20869 P; 22.08.1996 US 24405 P; 26.08.1996 US 24555 P; 13.11.1996 US 30697 P; 13.12.1996 US 32666 P; 31.12.1996 US 34053 P; 15.01.1997 US 784862; 24.01.1997 US 788740; 18.02.1997 US 802054; 17.03.1997 US 819464
(43) Date of publication of application: 06.05.1998
(60) Divisional application: 04018676.9
(73) Proprietor: FormFactor, Inc., Livermore, CA 94550 (US)
(72) Inventor: KHANDROS, Igor, Y., Orinda, CA 94563 (US); ELDRIDGE, Benjamin, N., Danville, CA 94526 (US); MATHIEU, Gaetan, L., Livermore, CA 94550 (US); GRUBE, Gary, W., Pleasanton, CA 94588 (US)
(74) Representative: Käck, Jürgen, Dipl.-Ing.
(86) International application number: PCT/US1997/008271
(87) International publication number: WO 1997/044676

(56) References cited:
- WO-A-94/09513
- WO-A-95/14314
- DE-U- 9 004 562
- US-A- 5 475 318
- LEUNG J ET AL: "ACTIVE SUBSTRATE MEMBRANE PROBE CARD" TECHNICAL DIGEST OF THE INTERNATIONAL ELECTRON DEVICES MEETING (IEDM), WASHINGTON, DEC. 10 - 13, 1995, 10 December 1995, INSTITUTE OF ELECTRICAL AND ELECTRONIC ENGINEERS, pages 709-712, XP000624791
- KONG L C ET AL: "INTEGRATED ELECTROSTATICALLY RESONANT SCAN TIP FOR AN ATOMIC FORCE MICROSCOPE" JOURNAL OF VACUUM SCIENCE AND TECHNOLOGY: PART B, vol. 11, no. 3, 1 May 1993, pages 634-641, XP000383159

## Description

### TECHNICAL FIELD OF THE INVENTION

The present invention relates to resilient electrical contact (interconnection) elements (structures), also referred to as spring contacts, suitable for effecting pressure connections between electronic components and, more particularly, to microminiature spring contacts such as may be used in probing (resiliently and temporarily contacting) microelectronic components such as active semiconductor devices.

### BACKGROUND OF THE INVENTION

Commonly-owned U.S. Patent Application No. 08/152,812 filed 16 Nov 93 (now USP 4,576,211, issued 19 Dec 95), and its counterpart commonly-owned copending "divisional" U.S. Patent Applications Nos. 08/457,479 filed 01 Jun 95 (status: pending) and 08/570,230 filed 11 Dec 95 (status: pending), all by KHANDROS, disclose methods for making resilient interconnection elements for microelectronics applications involving mounting an end of a flexible elongate core element (e.g., wire "stem" or "skeleton") to a terminal on an electronic component coating the flexible core element and adjacent surface of the terminal with a "shell" of one or more materials having a predetermined combination of thickness, yield strength and elastic modulus to ensure predetermined force-to-deflection characteristics of the resulting spring contacts. Exemplary materials for the core element include gold. Exemplary materials for the coating include nickel and its alloys. The resulting spring contact element is suitably used to effect pressure, or demountable, connections between two or more electronic components, including semiconductor devices.

Commonly-owned, copending U.S. Patent Application No. 08/340,144 filed 15 Nov 94 and its corresponding PCT Patent Application No. PCT/US94/13373 filed 16 Nov 94 (WO95/14314, published 26 May 95), both by KHANDROS and MATHIEU, disclose a number of applications for the aforementioned spring contact element, and also disclosed techniques for fabricating contact pads at the ends of the spring contact elements. For example, in Figure 14 thereof, a plurality of negative projections or holes, which may be in the form of inverted pyramids ending in apexes, are formed in the surface of a sacrificial layer (substrate). These holes are then filled with a contact structure comprising layers of material such as gold or rhodium and nickel. A flexible elongate element is mounted to the resulting contact structure and can be overcoated in the manner described hereinabove. In a final step, the sacrificial substrate is removed. The resulting spring contact has a contact pad having controlled geometry (e.g., sharp points) at its free end.

Commonly-owned, copending U.S. Patent Application No. 08/452,255 filed 26 May 95 and its corresponding PCT Patent Application No. PCT/US95/14909 filed 13 Nov 95 (WO96/17278, published 06 Jun 96), both by ELDRIDGE, GRUBE, KHANDROS and MATHIEU, disclose additional techniques and metallurgies for fabricating contact tip structures on sacrificial substrates, as well as techniques for transferring a plurality of spring contact elements mounted thereto, en masse, to terminals of an electronic component (see, e.g., Figures 11A-11F and 12A-12C therein).

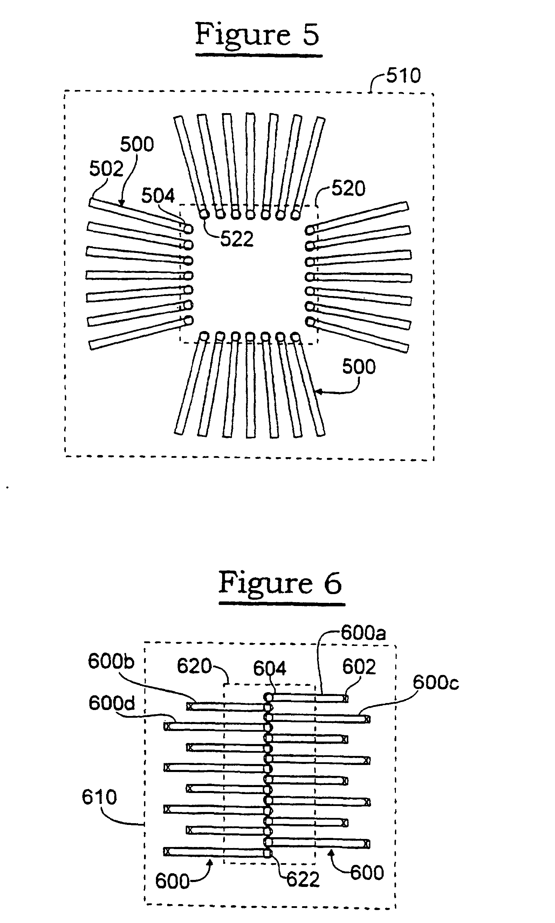

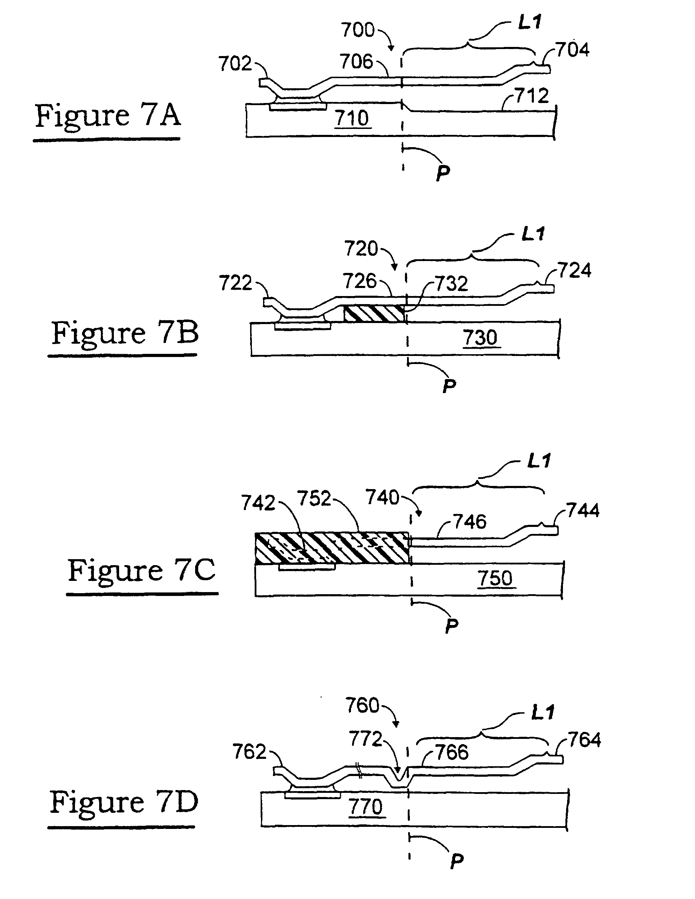

Commonly-owned, copending U.S. Provisional Patent Application No. 60/005,189 filed 17 May 96 and its corresponding PCT Patent Application No. PCT/US96/08107 filed 24 May 96 (WO96/37332, published 28 Nov 96), both by ELDRIDGE, KHANDROS, and MATHIEU, discloses techniques whereby a plurality of contact tip structures (see, e.g, #620 in Figure 6B therein) are joined to a corresponding plurality of elongate contact elements (see, e.g., #632 of Figure 6D therein) which are already mounted to an electronic component (#630). This patent application also discloses, for example in Figures 7A-7E therein, techniques for fabricating "elongate" contact tip structures in the form of cantilevers. The cantilever tip structures can be tapered, between one end thereof and an opposite end thereof. The cantilever tip structures of this patent application are suitable for mounting to already-existing (i.e., previously fabricated) raised interconnection elements (see, e.g., #730 in Figure 7F) extending (e.g., free-standing) from corresponding terminals of an electronic component (see. e.g., #734 in Figure

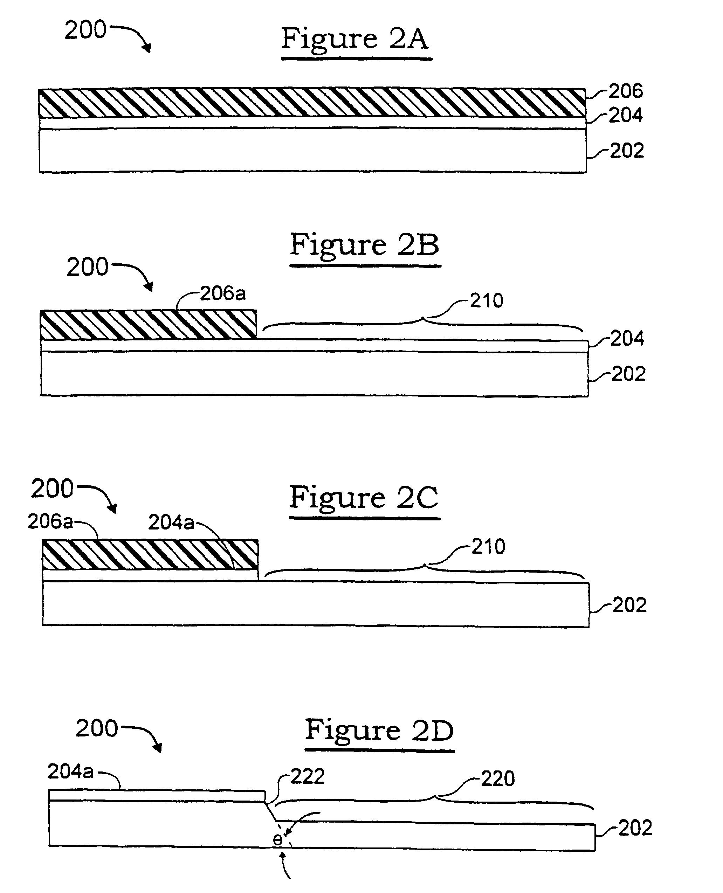

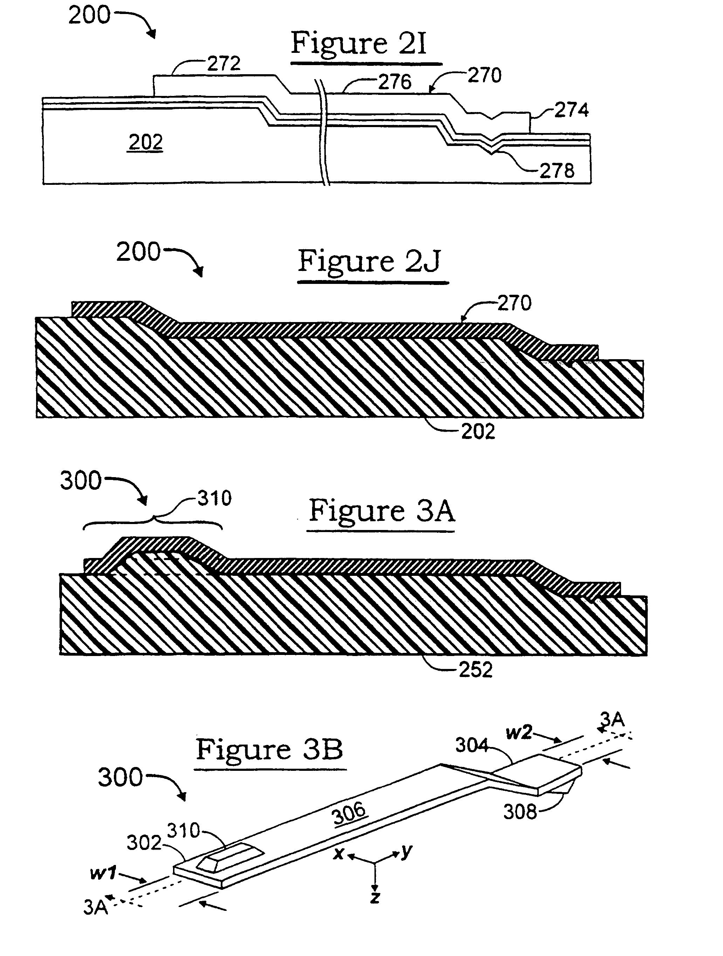

Commonly-owned, copending U.S. Provisional Patent Application No. 60/024,555 filed 26 Aug 96, by ELDRIDGE, KHANDROS and MATHIEU, discloses, for example at Figures 2A-2C thereof, a technique whereby a plurality of elongate tip structures having different lengths than one another can be arranged so that their outer ends are disposed at a greater pitch than their inner ends. Their inner, "contact" ends may be collinear with one another, for effecting connections to electronic components having terminals disposed along a line, such as a centerline of the component.

The present invention addresses and is particularly well-suited to making interconnections to modern microelectronic devices having their terminals (bond pads) disposed at a fine-pitch. As used herein, the term **"fine-pitch"** refers to microelectronic devices that have their terminals disposed at a spacing of less than 127 µm (5 mils), such as 2.5 mils or 65 µm. As will be evident from the description that follows, this is preferably achieved by taking advantage of the close tolerances that readily can be realized by using lithographic rather than mechanical techniques to fabricate the contact elements.

WO 94/09513 A1 discloses an interconnection structure for integrated circuits wherein the interconnection structure is formed on a supporting substrate. The interconnection structure includes a protrusion which is covered by a metallization layer.

The contact element in DE 90 04 562. 9 U is arranged over a cavity formed in a support substrate. The base end of the elongate contact element is connected to a side wall of the cavity and the middle portion extends freestanding over the cavity. The contact end of the element includes a contact tip projecting from the support substrate surface. The contact element may be deflected into the cavity during contacting.

An interconnection element of WO 95/14314 A1 is formed by bonding a wire to the contact pad which is previously formed in a sacrificial substrate. The free end of the wire is connected to a pad on an electronic component. Finally the sacrificial substrate is removed.

### SUMMARY OF THE INVENTION

An object of the present invention is to provide an electronic interconnection apparatus and a method for fabricating spring contact elements, wherein the spring contact elements have improved contacting properties.

The invention is defined in claims 1, 5, 7, 10 and 13, respectively. Particular embodiments are set out in the dependent claims.

According to the invention, an elongate spring contact element suitable for microelectronic applications is fabricated by forming depressions (such as trenches, such as by etching) in a sacrificial substrate and depositing (such as by plating) metallic materials into the depressions. A plurality of spring contact elements may be fabricated in this manner on a single sacrificial substrate, with lithographically-defined tolerances (e.g., dimensions, spacings).

The resulting spring contact elements may then be mounted to another substrate such as a passive substrate or an active substrate such as a semiconductor device, after which the sacrificial substrate is removed.

An exemplary spring contact element formed in this manner has a length "**L**" between its base end and its contact end. The base end is preferably offset in a first direction from a central portion of the spring contact element, and the contact end is preferably offset in an opposite direction from the central portion. In this manner, the overall spring contact element is not planar and, when its base end is mounted to an electronic component, its contact end extends above the surface of the electronic component to which it is mounted.

An exemplary sacrificial substrate upon which the spring contact elements may be fabricated is a silicon wafer, in which case the process of the present invention advantageously utilizes the directionally selective etching of silicon used for micro-machining processes to create an electroform which is used to plate up the final spring contact element. This approach may optionally employ laser-based ablation of photoresist, as opposed to lithographic development of the photoresist, in order to create the high aspect ratio of width to height which is required for fine pitch spacings between the spring contact elements.

An exemplary application for the spring contact elements of the present invention is as probe elements used to effect pressure connections between a substrate and a device-under-test (DUT), in which case the spring contact elements are suitably mounted to a space transformer component of a probe card assembly, such as is described in the aforementioned **08/554,902** and **PCT/US95/14844**. Alternatively, the spring contact elements are mounted to and extend from an active electronic component such as an application specific integrated circuit (ASIC).

The spring contact element is suitably formed of at least one layer of a metallic material selected for its ability to cause the resulting contact structure to function, in use, as a spring (i.e., exhibit elastic deformation) when force is applied to its contact (free) end.

In an embodiment, the resulting spring contact element may be preferably "long and low", having:
● a length **"L",** as measured from one end to another end;
● a height **"H"** measured transverse the length in a direction that is normal (z-axis) to the surface of the sacrificial substrate (and, normal to the component to which the spring contact element is ultimately mounted);
● a contact end portion which is offset in a one direction (e.g., negative along the z-axis) from a central portion of the spring element by a distance **"d1"**; and
● a base end portion which is offset in one direction (e.g., positive z-axis) from the central portion of the spring element by a distance **"d2".**

The spring contact element is preferably tapered from the one (base) end to the other (contact) end thereof, the spring contact element having the following dimensions:
● a width **"w1"** at its base end as measured parallel to the surface of the sacrificial substrate and transverse to the longitudinal axis of the spring element;
● a width **"w2"** at its contact end as measured parallel to the surface of the sacrificial substrate and transverse to the longitudinal axis of the spring element;
● a thickness "**t1**" at its base end, measured along the z-axis; and
● a thickness **"t2"** at its contact end, measured along the z-axis;
resulting in:
● a widthwise taper angle "α" (alpha); and
● a thickness taper angle "β" (beta).

The spring contact element is also suitably provided with a projecting feature at its contact end, said feature having a dimension **"d3"** measured along the z-axis.

There is thus described herein an exemplary spring contact element suitable for effecting connections between two electronic components, typically being mounted by its base end to a one of the two electronic components and effecting a pressure connection with its contact end (e.g., by the projecting feature) to an other of the two electronic components, having the following dimensions (in mils, unless otherwise specified):

| dimension | range | preferred |
|---|---|---|
| L | 0.25 - 25.4 mm (10-1000) | (60 -100) 1,5 - 2.54 mm |
| H | 0.1-1.02 mm (4-40) | (5 -12) 127 - 305 µm |
| d1 | 76 - 381 µm (3-15) | (7±1) 178 ± 25.4 µm |
| d2 | 0 - 331 µm (0-15) | (7 ± 1) 178 ± 25.4 µm |
| d3 | 6.35 - 127 µm (0.25 - 5) | (3) 76 µm |
| w1 | 76 - 508 µm (3 - 20) | (8-12) 203 - 304 µm |
| w2 | 25.4 - 254 µm (1 - 10) | (2-8) 50 - 203 µm |
| t1 | 25.4 - 254 µm (1 - 10) | (2 - 5) 50 - 127 µm |
| t2 | 25.4 - 254 µm (1 - 10) | (1 - 5) 25.4 - 127 µm |
| α | 0 - 30° | 2 - 6° |
| β | 0 - 30° | 0 - 6° |

Other objects, features and advantages of the invention will become apparent in light of the following description thereof.

### Brief Description of the Drawings

Reference will be made in detail to preferred embodiments of the invention, examples of which are illustrated in the accompanying drawings. The drawings are intended to be illustrative, not limiting.

Although the invention will be described in the context of these preferred embodiments, it should be understood that it is not intended to limit the spirit and scope of the invention to these particular embodiments.

Certain elements in selected ones of the drawings are illustrated not-to-scale, for illustrative clarity.

Often, similar elements throughout the drawings are referred to by similar references numerals. For example, the element 199 may be similar in many respects to the element 299 in another figure. Also, often, similar elements are referred to with similar numbers in a single drawing. For example, a plurality of elements 199 may be referred to as 199a, 199b, 199c, etc.

**Figure 1A** is a cross-sectional view of a spring contact element, according to the invention.

**Figure 1B** is a plan view of the spring contact element of **figure 1A**, according to the invention.

**Figure 1C** is a cross-sectional view of an alternate embodiment of a spring contact element, according to the invention.

**Figure 1D** is an enlarged cross-sectional view of the spring contact element of **Figure 1C.**

**Figure 1E** is a cross-sectional view of an alternate embodiment of a spring contact element, according to the invention.

**Figures 2A - 2I** are cross-sectional views of a technique for fabricating spring contact elements on a sacrificial substrate, according to the invention.

**Figure 2J** is a cross-sectional view of a spring contact element residing on a sacrificial substrate, according to the invention.

**Figure 3A** is a cross-sectional view of an alternate embodiment of a spring contact element residing on a sacrificial substrate, according to the invention.

**Figure 3B** is a perspective view of the spring contact element of **Figure 3A,** omitting a showing of the sacrificial substrate, according to the invention.

**Figures 4A-4B** are cross-sectional views illustrating a technique for mounting a plurality of spring contact elements which initially are resident on a sacrificial substrate to another component such as a space transformer, according to the invention.

**Figure 4C** is a cross-sectional view of a plurality of spring contact elements mounted to a component such as a space transformer, in use, probing (making temporary pressure connections with) another component such as a semiconductor device, according to the invention.

**Figure 4D** is a cross-sectional view of another embodiment (compare **Figure 4B**) of a technique for mounting a plurality of spring contact elements to another component such as a space transformer, according to the invention.

**Figure 4E** is a cross-sectional view of another embodiment (compare **Figure 4B)** of a technique for mounting a plurality of spring contact elements to another component such as a space transformer, according to the invention. This figure also illustrates another embodiment of a spring contact element, according to the invention.

**Figure 4F** is a cross-sectional view of another embodiment (compare **Figure 4E**) of a technique for mounting a plurality of spring contact elements to another component such as a space transformer, according to the invention. This figure also illustrates another embodiment of a spring contact element, according to the invention.

**Figure 5** is a schematic (stylized) plan view illustration of an application (use) for the spring contact elements of the present invention.

**Figure 6** is a schematic (stylized) plan view illustration of another application (use) for the spring contact elements of the present invention.

**Figure 7A** is a cross-sectional view of another embodiment (compare **Figure 4D**) of a technique for mounting a spring contact element to another component such as a space transformer, according to the invention.

**Figure 7B** is a cross-sectional view of another embodiment (compare **Figure 7A)** of a technique for mounting a spring contact element to another component such as a space transformer, according to the invention.

**Figure 7C** is a cross-sectional view of another embodiment (compare **Figure 7A**) of a technique for mounting a spring contact element to another component such as a space transformer, according to the invention.

**Figure 7D** is a cross-sectional view of another embodiment (compare **Figure 7A**) of a technique for mounting a spring contact element to another component such as a space transformer, according to the invention.

**Figure 8A** is a perspective view of an alternate embodiment of a spring contact element (compare **Figure 3B**), omitting a showing of the sacrificial substrate, according to the invention.

**Figure 8B** is a perspective view of an alternate embodiment of a spring contact element (compare **Figure 8A**), omitting a showing of the sacrificial substrate, according to the invention.

**Figure 9A** is a side cross-sectional view of a first step in a technique for achieving controlled impedance in a spring contact element, according to the invention.

**Figure 9B** is a side cross-sectional view of a next step in the technique for achieving controlled impedance in a spring contact element, according to the invention.

**Figure 9C** is an end cross-sectional view of the controlled impedance spring contact element of **figure 9B**, according to the invention.

### DETAILED DESCRIPTION OF THE INVENTION

Commonly-owned, copending U.S. Patent Application No. 08/554,902 filed 09 Nov 95 and its corresponding PCT Patent Application No. PCT/US95/14844 filed 13 Nov 95 (WO96/15458, published 23 May 96), both by ELDRIDGE, GRUBE, KHANDROS and MATHIEU, disclose a probe card assembly which includes elongate resilient (spring) contact elements mounted to a "**space transformer**" component. As used herein, a **space transformer** is a multilayer interconnection substrate having terminals disposed at a first pitch on a one surface thereof and having corresponding terminals disposed at a second pitch on an opposite surface thereof, and is used to effect "pitch-spreading" from the first pitch to the second pitch. In use, the free ends (tips) of the elongate spring contact elements make pressure connections with corresponding terminals on an electronic component being probed (e.g., tested).

### ELONGATE. RESILIENT CANTILEVER-LIKE CONTACT ELEMENT

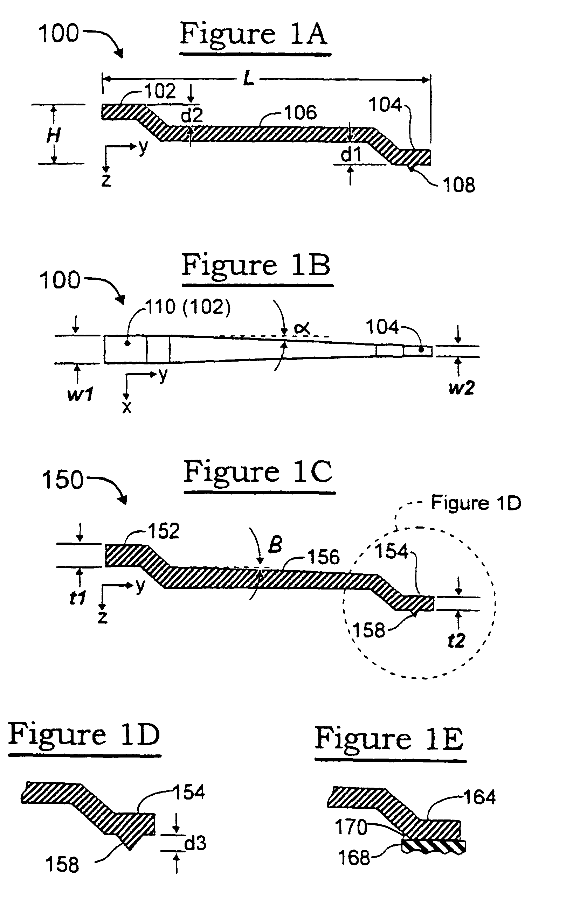

**Figures 1A and 1B** illustrate an elongate resilient (spring) contact element 100 that is suitable for attachment as a free-standing structure to an electronic component including, but not limited to, the space transformer of the aforementioned probe card assembly.

The structure 100 is elongate, has two ends 102 and 104, a central portion 106 therebetween, and has an overall longitudinal length of "L" between the two ends. The length **"L"** is in the range of 0.25 - 25.4 mm (10 - 1000 mils), such as 1.02 - 12.7 mm (40 - 500 mils) or 1.02 - 6.35 mm (40 - 250 mils), preferably 1.5 - 2.34 mm (60-100 mils). As will become apparent from the discussion that follows, in use the structure has an effective length of **"L1",** less than **"L",** which is the length over which the structure can flex in response to a force applied thereto.

The end 102 is a "base" whereat the contact element 100 will be mounted to an electronic component (not shown). The end 104 is a "free-end" (tip) which will effect a pressure connection with another electronic component (e.g., a device-under-test, not shown). Although not illustrated, it is also possible that the contact element 100 has an elongate "tail" portion extending beyond the base end 102, opposite the central portion 106.

The structure 100 has an overall height of "H". The height "H" is in the range of 0.1 - 1.02 mm (4-40 mils), preferably 127 - 305 µm (5 - 12 mils). (1 mil = 0.001 inches)

As best viewed in **Figure 1A,** the structure is "stepped". The base portion 102 is at a first height, the tip 104 is at another height, and a middle (central) portion 106 is at a third height which is between the first and second heights. Therefore, the structure 100 has two "standoff" heights, labelled **"d1"** and **"d2"** in the figure. In other words, the spring contact element 100 has two "steps", a step up from the contact end 104 to the central body portion 106, and a further step up from the central body portion 106 to the base end 102.

In use, the standoff height **"d1",** which is the "vertical" (as viewed in **Figure 1A)** distance between the tip 104 and the central portion 106, performs the function of preventing bumping of the structure (contact element) with a surface of a component being contacted by the tip end 104.

In use, the standoff height "d2", which is the "vertical" (as viewed in **Figure 1A**) distance between the base 102 and the central portion 106, performs the function of allowing the beam (contact element) to bend through the desired overtravel.

The dimensions for the standoff heights "d1" and "d2" are:
- "d1" is in the range of 76 - 381 µm (3 - 15 mils), preferably approximately 178 + 25 µm (7 mils + 2 mil); and
- "d2" is in the range of 0 - 381 µm (0 - 15 mils), preferably approximately 178 + 25 µm (7 mils + 1 mil). In the case of "d2" being 0 µm (0 mil), the structure would be substantially planar (without the illustrated step) between the central portion 106 and the base portion **102.**

As best viewed in **Figure 1B,** the structure 100 is preferably provided with a "joining feature" 110 at its base portion 102. The joining feature may be a tab or, optionally a stud, which is used to facilitate brazing the probe structure to a substrate (e.g., a space transformer or a semiconductor device) during assembly therewith. Alternatively, the component or substrate to which the structure 100 is mounted may be provided with a stud or the like to which the base portion 102 is mounted.

In use, the structure 100 is intended to function as a cantilever beam, and is preferably provided with at least one taper angle, labelled "α" in **Figure 1B**. For example, the width "w1" of the structure 100 at its base end 102 is in the range of 127 - 508 µm (5 - 20 mils), preferably 203 - 304 µm (8 - 12 mils), and the width "w2" of the structure 100 at its tip end 104 in the range of 25.4 - 254 µm (1 - 10 mils), preferably 50 - 203 µm (2 - 8 mils), and the taper angle "α" is preferably in the range of 2 - 6 degrees. The narrowing of (taper) the structure 100, from its base 102 to its tip 104, permits controlled flexure and more even stress distribution (versus concentration) of the structure 100 when its base 102 is secured (immovable) and a force is applied at its tip (104).

As will be evident in the discussion presented hereinbelow, the width of the structure (hence, the taper angle "α") is readily controlled employing well-known lithographic techniques.

The tip end 104 of the structure 100 is preferably provided with an integral protruding topological feature 108, for example in the geometric form of a pyramid, to aid in effecting pressure connection to a terminal of an electronic component (not shown) .

As illustrated in **Figures 1A and 1B,** the spring contact element 100 is three-dimensional, extending in the x- y- and z-axes. Its length "L" is along the y-axis, its widths (**"w1"** and **"w2"**) is along the x-axis, and its thicknesses (**"t1"** and **"t2"**) and height ("H") are along the x-axis. As will become evident in the discussion set forth hereinbelow (see, e.g. , **Figure 4B),** when the spring contact element 100 is mounted to an electronic component, it is mounted thereto so that the length and width of the spring contact element are parallel to the surface of the electronic component, and its height is normal to the surface of the electronic component.

**Figure 1C** illustrates a contact structure 150 similar in most respects to the structure 100 of **Figures 1A and 1B.** The structure is elongate, has a base end 152 (compare 102) and a tip end 154 (compare 104), and a topological feature 158 (compare 108) incorporated into its tip end. The principal difference being illustrated in **Figure 1C** is that the structure can be provided with a second taper angle "β".

As best viewed in **Figure 1C**, the thickness "**t1**" of the structure 100 at its base end 102 is in the range of 25.4 - 254 µm (1 - 10 mils), preferably 50 - 127 µm (2 - 5 mils), and the thickness "**t2**" of the structure 100 at its tip end 104 in the range of 25.4 - 254 µm (1 - 10 mils), preferably 25.4 - 127µm (1 - 5 mils), and the taper angle "β" is preferably in the range of 2- 6 degrees.

The angle "β" (**Figure 1C**) may be created using various methods for controlling the thickness distribution. For example, if the structure 100 is formed by plating, a suitable plating shield can be incorporated into the bath. If the structure 100 is formed other than by plating, appropriate known processes for controlling the spatial distribution of thickness of the resulting structure would be employed. For example, sandblasting or electro-discharge machining (EDM) the structure 100.

Thus, the structure suitably has a composite (dual) taper from its base end 102 to its tip end 104. It has a taper angle "α" which, as will be evident from the description of a contact structure mounted to a component or substrate set forth hereinbelow, is parallel to the x-y plane of the substrate or component to which the contact structure 100 is mounted. And it has a taper angle "β" which represents a narrowing of the structure's cross section (z-axis).

It is within the scope of this invention that the structure is not tapered in width, in which case the taper angle "α" would be ZERO. It is also within the scope of this invention that the taper angle "α" is greater than 2-6 degrees, for example as much as 30 degrees. It is within the scope of this invention that the structure is not tapered in thickness, in which case the taper angle "β" would be ZERO. It is also within the scope of this invention that the taper angle "β" is greater than 2-6 degrees, for example as much as 30 degrees. It is within the scope of this invention that the structure (contact element) is tapered only in thickness and not in width, or only in width and not in thickness.

It is within the scope of this invention that the contact element is tapered to be wider and/or thicker at its contact end 104 than at its base end 102, rather than narrower and/or thinner as described above. It is also possible that the contact element is provided with a plurality of different tapers, for example, tapering in (e.g., wider to narrower) from the base end to the central portion, then tapering back out (e.g., narrow to wider) towards the contact end.

The contact structures 100 and 150 are principally, preferably entirely, metallic, and may be formed (fabricated) as multilayer structures, as is described in greater detail hereinbelow. Suitable materials for the one or more layers of the contact structures include but are not limited to:
nickel, and its alloys;
copper, cobalt, iron, and their alloys;
gold (especially hard gold) and silver, both of which exhibit excellent current-carrying capabilities and good contact resistivity characteristics;
elements of the platinum group;
noble metals;
semi-noble metals and their alloys, particularly elements of the palladium group and their alloys; and
tungsten, molybdenum and other refractory metals and their alloys.

In cases where a solder-like finish is desired, tin, lead, bismuth, indium and their alloys can also be used.

**Figure 1D** shows an enlarged view of the contact end 154 of the contact structure 150 (equally applicable to the contact ends of other contact structures illustrated herein). In this enlarged view it can be seen that the contact feature 154 is suitably quite prominent, projecting a distance "**d3**", in the range of 6.35 - 127µm (0.25 - 5 mils), preferably 76 µm (3 mils) from the bottom (as viewed) surface of the contact end of the spring contact element, and is suitably in the geometric shape of a pyramid, a truncated pyramid, a wedge, a hemisphere, or the like.

The resulting spring contact element has an overall height "H" which is the sum of **"d1", "d2"** (and **"d3")** plus the thickness of the central body portion.

There has thus been described a exemplary spring contact element suitable for effecting connections between two electronic components, typically being mounted by its base end to a one of the two electronic components and effecting a pressure connection with its contact end to an other of the two electronic components, having the following dimensions (in mils, unless otherwise specified):

| dimension | range | preferred |
|---|---|---|
| L | 0.25 - 25.4 mm (10 - 1000) | (60 - 100) 1.5 - 2.54 mm |
| H | 0.1 - 1.02 mm (4 - 40) | (5 - 12) 127 - 305 µm |
| d1 | 76 - 381 µm (3 - 15) | (7 ± 1) 178 ± 25.4 µm |
| d2 | 0 - 381 µm (0 - 15) | (7 ± 1) 178 ± 25.4 µm |
| d3 | 6.35 - 127 µm (0.25 - 5) | (3) 76 µm |
| w1 | 76 - 508 µm (3 - 20) | (8 - 12) 203 - 304 µm |
| w2 | 25.4 - 254 µm (1 - 10) | (2 - 8) 50 - 203 µm |
| t1 | 25.4 - 254 µm (1 - 10) | (2 - 5) 50 - 127 µm |
| t2 | 25.4 - 254 µm (1 - 10) | (1 - 5) 25.4 - 127 µm |
| α | 0 - 30° | 2 - 6° |
| β | 0 - 30° | 0 - 6° |

from which the following general relationships are evident:
**"L"** is approximately at least 5 times **"H";**
**"d1"** is a small fraction of **"H",** such as between one-fifth and one-half the size of **"H";**
**"w2"** is approximately one-half the size of **"w1",** and is a small fraction of **"H",** such as between one-tenth and one-half the size of **"H";** and
**"t2"** is approximately one-half the size of **"t1",** such as between one-tenth and one-half the size of **"H".**

Another dimension is of interest - namely, the width and length (i.e.; footprint) of the overall tip end (104). In instances where the tip end is expected to make contact with a terminal of an electronic component which is recessed (e.g., a bond pad of a semiconductor device which has passivation material surrounding the bond pad), it may be desirable to ensure that the footprint of the tip end is sufficiently small to make such contact. For example, less than 0.1 mm (4 mils) by 0.1 mm (4 mils). Else, it must be ensured that the contact feature (108) is of sufficient height **(d3)** to make contact with the recessed terminal. Generally speaking, the selection of an appropriate tip end design will be dictated by the peculiarities of the given application. For example, for contacting bond pads on silicon devices, the tip end design illustrated in **Figure 1D** would likely be most appropriate. For contacting C4 bumps, the tip end design illustrated in **Figure 1E** (described hereinbelow) would likely be most appropriate.

**Figure 1E** illustrates an alternate embodiment of the invention wherein discrete contact tip structures 168, such as are described in the aforementioned **PCT/US96/08107** can be mounted to the contact end portions 164 of the spring contact elements, such as by brazing 170 thereto. This provides the possibility of the contact tip structure 168 having a different metallurgy, than the spring contact element (150). For example, the metallurgy of the spring contact element (150) is suitably targeted at its mechanical (e.g., resilient, spring) characteristics and its general capability to conduct electricity, while the metallurgy of a contact tip structure 168 mounted thereto is appropriately targeted to making superior electrical connection with a terminal (see, e.g., 420, hereinbelow) of an electronic component (see, e.g., 422, hereinbelow) being contacted and, if needed, can have superior wear-resistance.

### FABRICATING THE CONTACT STRUCTURE

A contact element such as that described hereinabove would be difficult, to punch out of a foil of spring material and mount in a precise location on an electronic component such as a space transformer, at the scale (dimensions) described herein.

According to an aspect of the invention, processes such as photolithography are employed to fabricate the spring contact elements of the present invention with tolerances, both of the springs themselves and with regard to the relative locations of a plurality of springs, suitable for use as interconnections in the context of fine-pitch microelectronics.

**Figures 2A-2J** illustrates an exemplary process 200 for fabricating the aforementioned resilient contact structures 100 (150). The present invention is not limited to this exemplary process.

As illustrated in **Figure 2A**, commencing with a suitable sacrificial substrate 202, such as a silicon wafer, a blanket layer 204 of silicon nitride ("nitride") is applied to the surface of the sacrificial substrate. This layer 204 will act as an etch stop in subsequent steps of the process. A layer 206 of a masking material, such as photoresist, is applied over the nitride layer 204, and is imaged and developed using conventional photolithographic techniques (e.g., actinic light passing through a mask).

It is within the scope of this invention that the sacrificial substrate is a material selected from the group consisting of silicon, aluminum, copper, ceramic, and the like. For example, silicon in the form of a silicon semiconductor wafer. Or aluminum or copper in the form of a foil or sheet. Or, aluminum or copper in the form of a layer on another substrate. The sacrificial substrate can also be a "clad" (multilayer) structure, such as copper-invar-copper or aluminum-alumina-aluminum, and preferably has a coefficient of thermal expansion which matches that of the component to which the contact structures are ultimately mounted. The example set forth herein, vis-a-vis the "machining" of the sacrificial substrate is applicable to sacrificial substrates which are silicon. One of ordinary skill in the art to which the present invention most nearly pertains will readily understand how to achieve comparable results with sacrificial substrates formed of other (than silicon) materials. It is within the scope of this invention that the sacrificial substrate can be formed of titanium-tungsten which is readily etched with hydrogen peroxide.

Using conventional chemical etching techniques, an opening 210 to the surface of the sacrificial substrate 202 can be created through both of the layers 206 and 204, as illustrated in **Figure 2C**. In the area of the opening 210, the surface of the sacrificial substrate is exposed. The surface of the sacrificial substrate is covered by the residual (remaining) portions 204a and 206a of the layers 204, 206, respectively, that are not removed by etching.

Alternatively, as illustrated in **Figure 2B,** selected portions of the photoresist 206 can be removed employing other techniques, such as known techniques involving lasers, E-beam, and the like, and the resulting exposed (no longer covered) portions of the nitride layer 204 can be removed using chemical etching processes, the result of which is that an opening 210 to the surface of the sacrificial substrate 202 can be created, as illustrated in **Figure 2C**. Using a laser to remove portions of the masking layer 206 (other portions 206a being remaining portions) provides the possibility of having more carefully-controlled aspect ratios for the resulting openings 210, for example, obtaining steeper and deeper, more-vertical sidewalls in the opening.

In a next step of the process 200, illustrated in **Figure** **2D,** the sacrificial substrate 202 is etched in the openings 210 through the nitride layer 204, using known chemistry for selectively etching the substrate. For example, a silicon substrate can selectively be etched (with respect to nitride) using potassium hydroxide (KOH). This will create a trench 220 in the substrate 202, the depth of which is controlled to correspond to the aforementioned standoff height **"d2"** (see **Figure 1A).** Also, in the case of employing a silicon wafer as the substrate 202, the sidewall 222 of the trench will favorably exhibit a non-vertical angle "θ", such as 54.74° (rather than 90°), as may be inherent in and controlled by the crystalline structure of the substrate. For example, a silicon substrate having a (100) crystal orientation when etched will etch in the (111) planes.

After creating the trench 220, the residual portion 204a of the etch stop layer 204 is preferably removed.

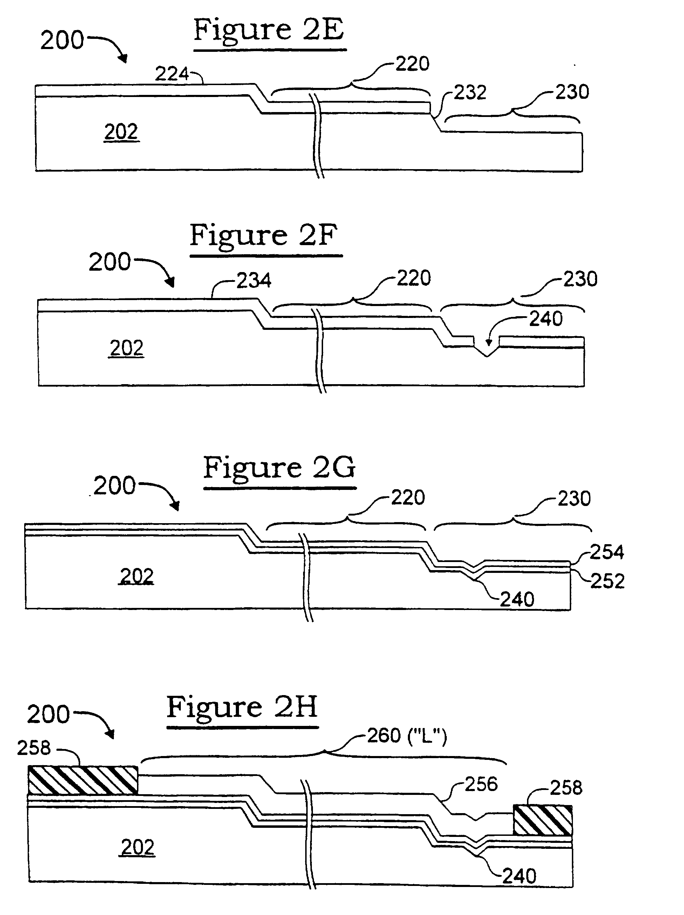

In a next step of the process 200, illustrated in **Figure 2E,** the previous steps illustrated and described with respect to **Figures 2A-2D** are repeated, to create another trench 230 in the sacrificial substrate 202 that is longitudinally offset from and contiguous with the trench 220. Alternatively, the trench 230 can be formed in an end portion (right hand side, as viewed) of the previously-formed trench 220. In other words, an etch stop layer 224 (compare 204) is applied, a masking layer (not shown, compare 206) is applied over the etch stop layer, an opening is created through the masking layer and the etch stop layer, and the substrate is etched. This will result in a trench 230 in the substrate 202, the depth of which is controlled to correspond to the aforementioned standoff height "**d1**" (see **Figure 1A).** Also, as mentioned hereinabove, in the case of employing a silicon wafer as the substrate 202, the sidewall 232 of the trench 230 will favorably be "angled", rather than vertical.

In a next step of the process 200, illustrated in **Figure 2F,** the previous steps illustrated and described with respect to **Figures 2A-2D** are repeated, to create a small geometric intrusion (depression) 240 (compare **"d3"** of **Figure 1D**) in the sacrificial substrate 202 in the bottom of the second trench 230. (The term **"intrusion"** is selected as being the complement to "negative of" the resulting protruding feature (108) that will be fabricated on the resulting spring contact element. The feature 240 could also be considered to be a **"depression",** a **"recess",** an **"indentation"** or an **"intaglio"**.) Namely, an etch stop layer 234 (compare 204, 224) is applied, a masking layer (not shown, compare 206) is applied over the etch stop layer, a small opening is created through the masking layer and the etch stop layer, and the substrate is etched. The shape of the intrusion 240 is suitably that of an inverted (as viewed) pyramid and, as mentioned hereinabove, may suitably have sides at the crystalline angle of silicon. As will be evident from the description hereinbelow, this intrusion 240 will define the topological feature 108 present on the tip of the contact structure 100 described hereinabove (pyramid, truncated pyramid, etc.). Finally, the nitride layer 234 is removed.

Each of the trenches 220 and 230 can be considered to be a "subtrench" of a larger overall trench which also includes the depression 240.

The steps described in **Figures 2A-2F** describe the preparation of a sacrificial substrate for the fabrication of resilient contact structures thereon. It is within the scope of this invention that certain of the steps described hereinabove could be performed in other than the recited order. For example, the trench 230 could be formed prior to forming the trench 220.

It bears mention here that it is within the scope of this invention that the process described hereinabove could be carried out on a silicon wafer that has active devices already formed therein. However, as is evident, the forming of trenches (220 and 230) and features (240) could well destroy the active devices unless (i) they were to be formed at areas of the wafer that do not contain active devices, or (ii) the spring contact elements were fabricated on a sacrificial substrate then attached to active devices (see e.g., **Figures 4A-4B** hereinbelow), or (iii) a layer of material suitable for performing the function of the sacrificial substrate (202) described hereinabove is first applied to the surface of the wafer.

As described hereinabove, the sacrificial substrate has been prepared with a first trench 220 which is lower than (extends into) the surface of the substrate, a second trench 230 which is lower than (extends deeper into) and is contiguous (end-to-end) with the first trench 220, and an intrusion (negative projection, depression) 240 within the second trench 230 which extends yet deeper into the substrate. Contact elements will be fabricated in these trenches, then will need to be "released" from the trenches.

In a next step of the process 200, illustrated in **Figure 2G,** one or more metallic layers are blanket deposited, such as by sputtering, onto the substrate 202. For example, a layer 252 of aluminum followed by a layer 254 of copper. Exemplary thicknesses for these layers are:
- 500 - 5,000 nm (5000 - 50,000 Å), preferably 2,000 nm (20,000 Å) for the first layer 252; and
- 100 - 5,000 nm (1000 - 50,000 Å), preferably 500 nm (5,000 Å) for the second layer 254.

The purposes of these layers 252 and 254 are generally:
- the first layer 252 is a material (such as aluminum) selected for its eventual use as a "release" layer (described hereinbelow); and
- the second layer 254 serves as a "seed" layer for deposition of a subsequent layer (256, described hereinbelow) and, in the case of a previous aluminum layer 252, will prevent the subsequent layer 256 from "smutting" as a result of removing the previous "release" layer 252. This layer may be removed from the final spring contact element and may act as a protective "capping" layer during the release process.

Together, the layers 252 and 254 constitute a "release mechanism" which is incorporated into the sacrificial substrate which, in use, permits the sacrificial substrate to be removed after the spring contact elements fabricated thereon (as described hereinbelow) are mounted to the terminals of the electronic component.

Metallic materials forming the resulting contact structures (100, 150) can be deposited into the trenches and features formed therein by any suitable technique including, but not limited to: various processes involving deposition of materials out of aqueous solutions; electrolytic plating; electroless plating; chemical vapor deposition (CVD); physical vapor deposition (PVD); processes causing the deposition of materials through induced disintegration of liquid or solid precursors; and the like, all of these techniques for depositing materials being generally well known. Electroplating is a generally preferred technique.

Next, as illustrated in **Figure 2H**, a masking layer 258 (compare 206), such as photoresist, is applied to the substrate and is patterned to have an openings 260 corresponding to the length **"L"** and width (**"w1"** and **"w2",** and widths therebetween) of the desired resulting spring contact element (see **Figures 1A and 1B**). A relatively thick "structural" metallic layer 256 is deposited within the openings 260, using any suitable process such as electroplating of a suitable material such as nickel, atop the previously applied layers 252 and 254. This layer 256 is intended to control (dominate) the mechanical characteristics of the resulting spring contact element (100). The opening 260 includes the trench 220, the trench 230, the depression 240 and a portion of the substrate 202 which is adjacent and contiguous with the first trench 220.

An exemplary average ((t1 + t2) / 2) thickness for this layer 256 is 25.4 - 254 µm (1 - 10 mils), preferably 25.4 - 127 µm (1-5 mils). Suitable materials for the layer 256, such as nickel and its alloys, have been set forth hereinabove.

It is within the scope of this invention that additional layers may be included in the build-up of the contact structure. For example, prior to depositing the layer 256, a layer of a material selected for its superior electrical characteristics of electrical conductivity, low contact resistance, solderability, and resistance to corrosion may be deposited. For example, gold or rhodium (both of which are excellent contact materials), nickel-cobalt (a good material for brazing), gold (another good material for brazing), and the like.

In a next step of the process 200, illustrated in **Figure 2I,** the masking layer 258 is removed, exposing the layers 252 and 254. These layers are suitably selectively chemically etched, so that all that remains on the substrate is an elongate structure 270 (compare 100) having a one end 272 (compare 102), an other end 274 (compare 104), a central portion 276 (compare 106) and a raised topological feature 278 (compare 108) at its end 274. This elongate structure 270 is the resulting spring contact element.

**Figure 2J** is another cross-sectional view of the resulting structure 270, still resident upon the substrate, with the layers 252 and 254 omitted, for illustrative clarity. The similarity between this structure 270 and the spring contact element 100 of **Figure 1A** is readily apparent.

One having ordinary skill in the art to which the present invention most nearly pertains will recognize that the processes described hereinabove can readily be performed at a plurality of locations on a sacrificial substrate to result in a plurality of contact structures (270) having been fabricated at a plurality of precisely-controlled predetermined locations on the substrate 202. The process has been described with respect to one exemplary structure 270 being fabricated at one location, for purposes of illustrative clarity.

It is within the scope of this invention that rather than patterning a sacrificial substrate to have a plurality of trenches, each corresponding to a single resulting contact element, that a sacrificial substrate can be prepared with a single very wide set of trenches,(220, 230, 240), then deposit the metals (252, 254, 256), then perform an additional final masking and etching step to define the individual contact elements. Such a process would look similar to the process described hereinabove with respect to **Figures 2A-2G**, followed by blanket deposition of the metal (256) layers, followed by masking and etching to define the individual contact elements.

### AN ALTERNATE EMBODIMENT

**Figures 3A and 3B** illustrate another one of many possible embodiments for a contact structure 300 fabricated by the techniques described hereinabove. Instead of a flat connection tab (see 110), a somewhat truncated-pyramidal joining feature (stud) 310 is fabricated as an attachment feature at the base portion 304 of the contact structure 300. When the contact structure 300 is mounted to a substrate, such as a space transformer, this stud 310 will allow for some misalignment tolerance during assembly. The remaining portions of the contact structure 300 are comparable to those described hereinabove with respect to the contact structure 270 -namely, a central main body portion 306 (compare 276), a contact end portion 304 (compare 274), and a feature 308 (compare 278).

Thus, there has thus been shown an exemplary process for fabricating elongate resilient (spring) interconnection (contact) elements on a sacrificial substrate. This can be considered to be an "interim" product, awaiting further use, as follows:
Alternative A: These spring contact elements can simply be removed from the sacrificial substrate, resulting in a "bucket of springs" which may be attached, such as with automated equipment, to an electronic component, although the benefit of having lithographically (i.e., to very close tolerances) located the plurality of spring contact elements with respect to one another would be lost.
Alternative B: A more "viable" technique for installing the spring contact elements onto an electronic component, involving removing the sacrificial substrate after the contact structures resident thereon are mounted (by the base ends) to an electronic component or to a substrate, is described hereinbelow with respect to **Figures 4A-4C.**

### REMOVING THE SACRIFICIAL SUBSTRATE

With regard to either of the alternatives ("A" or "B", set forth hereinabove, a suitable mechanism must be employed for removing the sacrificial substrate (i.e, releasing the fabricating contact elements from the sacrificial substrate whereupon they reside). Exemplary suitable mechanisms include, but are not limited to:
● chemically etching to release the contact structures (e.g., 270) from the sacrificial substrate (202). As mentioned above, the aluminum layer 252 is readily selectively etched to cause separation of the contact structure 270 from the substrate 202. (The copper layer 254 helps prevent contamination of the layer 256 in such a process, and may ultimately be etched from the separated contact structure 270.)
● in lieu of the aluminum and copper layers described hereinabove, employing layers of materials that are non-wetting with respect to one another and/or that ball up when heated (e.g., lead, indium, tin), then heating the substrate 202 to cause the contact structures 270 to be released therefrom.

### MOUNTING THE CONTACTS TO A SUBSTRATE

As mentioned hereinabove, a plurality of contact structures (e.g., 270) fabricated upon a sacrificial substrate (e.g., 202) can be mounted (affixed) to another substrate or to an electronic component such as a space transformer.

**Figure 4A** illustrates a technique 400 wherein a plurality (two of many shown) of contact structures 402 (compare 100, 150, 270, 300) have been fabricated on a sacrificial substrate 404 (compare 202). The base end portions (compare 310) of the contact structures 402 are brought into contact with a corresponding plurality of terminals 406 on an electronic component 408 such as the aforementioned space transformer of a probe card assembly, whereupon the base end portions are suitably soldered or brazed 410 to the terminals 406.

It is within the scope of this invention that any suitable technique and/or material for affixing the base end portions of the contact structures (402) to terminals of an electronic component be employed, including brazing, welding (e.g., spot welding), soldering, conductive epoxy, tacking the contact structure in any suitable manner to the terminal and securely affixing the contact structure to the terminal by plating (e.g., electroplating), and the like.

The sacrificial substrate 404 is now removed, in any suitable manner such as those described hereinabove (e.g., chemical etching, heating), resulting in an electronic component (408) having spring contact elements (402) affixed thereto, as illustrated in **Figure 4B.**

As is evident in **Figure 4B,** a plurality of elongate spring contact elements can be mounted to an electronic component having a plurality of terminals on a surface thereof. Each spring contact element has a base end and a contact end opposite the base end, and is mounted by its base end to a corresponding terminal of the electronic component. The contact end of each spring contact element extends above the surface of the electronic component to a position which is laterally offset from its base end.

As mentioned hereinabove, when mounted, the contact structure 402 (compare 100) has an "effective" length of **"L1",** this being the length between the tip feature (compare 108) and the inwardmost position whereat the base end (compare 102) is affixed to the component 408. The "effective" length represents the length over which the contact structure can deflect in response to compressive forces applied at the tip end thereof (e.g., at the tip feature).

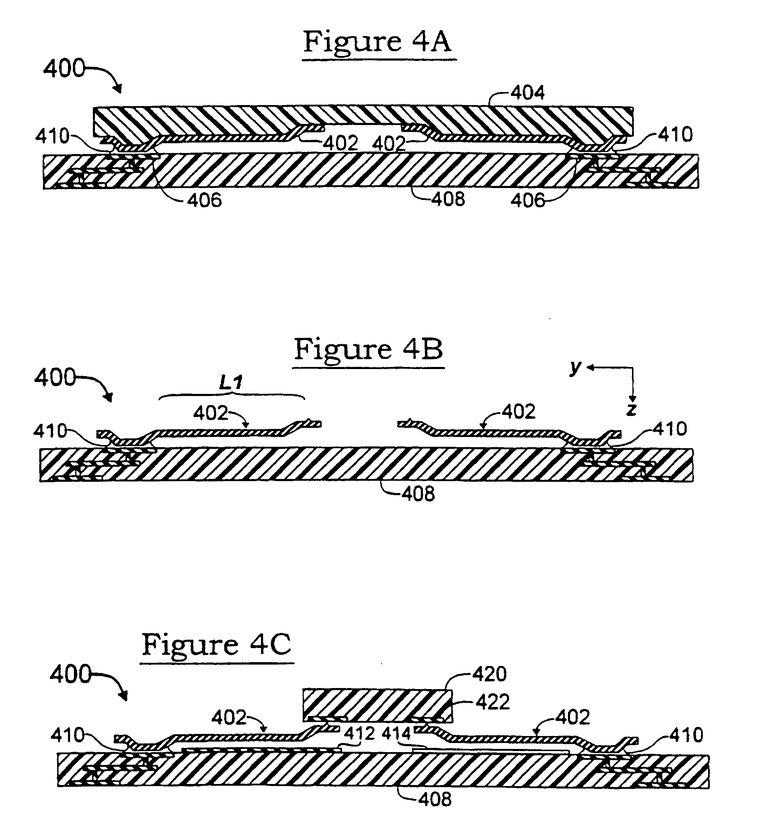

**Figure 4C** illustrates an application for the spring contact elements (resilient contact structures) of the present invention wherein the spring contact elements have been mounted in the manner described with respect to **Figure 4B** to a space transformer component (408) of a probe card assembly (not shown) so that the contact features (compare 308) at their contact ends (compare 304) make pressure connections with terminals 422 of an electronic component 420 such as a semiconductor device, or an area of a semiconductor wafer (not shown) containing a plurality of semiconductor devices. As described hereinabove, with respect to **Figure 1E,** it is within the scope of this invention that separate and discrete contact tip structures (168) be affixed to the contact end portions of the spring contact element.

It is within the scope of this invention that the substrate (component) to which the structures 402 are mounted, for example the component 408 illustrated in **Figure 4C** are active components, such as ASICs.

It is also within the scope of the invention, as is illustrated in **Figure 4C**, that the component or substrate to which the structures (e.g., 402) are mounted can be provided with a contiguous (as illustrated) or segmented ground plane to control impedance. Such a ground plane may comprise a plurality of ground lines 412 aligned directly underneath the structures 402, but sufficient clearance for the tip of the structure to deflect must be assured. Alternatively, the ground plane 412 can be covered with an insulating layer. Another approach would be to dispose ground plane lines 414 on the surface of the substrate 408 slightly (such as 1 mil, in the x-axis) offset from directly underneath the structures 402, and laying parallel to the structure.

**Figure 4D** illustrates an alternate embodiment 440 of the present invention wherein a cavity (trench) 442 is been formed in the surface of the substrate or component 444 (compare 408) to which the contact structures 450 (compare 402) have been mounted. The trench 442 is located so that it is underneath at least the contact end portion 454 (compare 104) of the contact structure, and preferably extends underneath a substantial portion of the contiguous central body portion 456 (compare 106) of the spring contact element. The trench extends of a depth "d4" within the substrate 444 a suitable distance to allow for a greater range of deflection of the contact end portion 454 when, in use, it is urged against an electronic component (see, e.g., **Figure 4C).** In **Figure 4D,** one trench 442 is illustrated extending under a plurality (two of many shown) spring contact elements. It is within the scope of this invention that there is a single discrete trench under each of the plurality of spring contact elements (450) structures mounted to an electronic component (444).

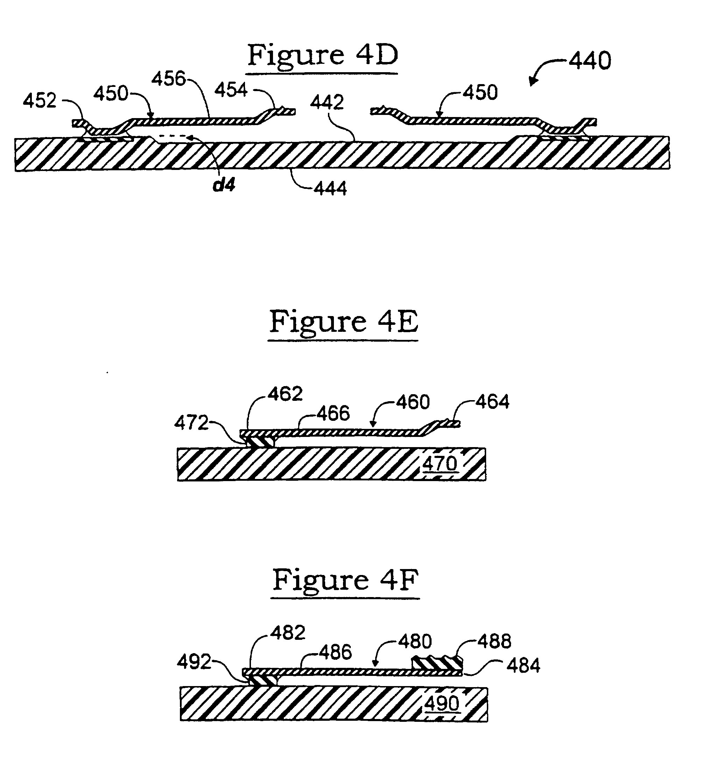

**Figure 4E** illustrates an alternate embodiment of the present invention wherein a spring contact element 460 is mounted to an electronic component 470 (compare 444) via a stud 472 extending from a surface of the electronic component 470. The base end 462 of the spring contact element 460 is suitably brazed to the stud 472. The stud 472 suitably has a height in the range of 76 - 102 µm (3 - 4 mils).
**Figure 4E** also illustrates an alternate embodiment of the present invention wherein the spring contact element 460 is formed with but a single step or offset (rather than two steps) . As illustrated herein, the offset of the base end portion 462 from the central body portion 466 (compare "**d2**" in **Figure 1A**) is ZERO. In other words, in this example, the base end portion 462 is coplanar with the central body portion 466. Since there is no offset at the base end portion, the base end 462 is mounted to a stud 472 on the surface of the electronic component 470 so that the body portion 466 is elevated above the surface of the component 470. The contact end portion 464 (compare 104) preferably remains offset by a distance "**d1**" from the central body portion 466. As suggested by this figure, many of the variations (alternate embodiments) of the present invention can be combined (mixed and matched) to arrive at a desired arrangement of spring contact elements affixed to an electronic component.

**Figure 4F** illustrates another embodiment of the invention wherein the spring contact element (contact structure) 480 is formed without any step or offset (rather than one or two steps). As in the previous example, the offset of the base end portion 482 from the central body portion 486 (compare **"d2"** in **Figure 1A**) is ZERO, and the base end portion 482 is coplanar with the central body portion 486. Since there is no offset at the base end portion, the base end 482 is mounted to a stud 492 on the surface of the electronic component 490 so that the body portion 486 is elevated above the surface of the component 490. Also, the offset of the contact end portion 484 (compare 104) from the central body portion 486 (compare **"d1"** in **Figure 1A**) is ZERO, and the contact end portion 484 is coplanar with the central body portion 486. Since there is no offset at the contact end portion, a prefabricated contact tip structure 488 (compare 168) may be affixed (e.g., joined, such as by brazing) to the contact end 484 so that the body portion 486 will be spaced away from a component (not shown, compare 420) being contacted by the contact structure 480.

### PROBE APPLICATIONS

**Figure 5** illustrates an application wherein a plurality of spring contact elements 500 such as those described hereinabove are arranged on a substrate such as a space transformer, and affixed thereto in the manner described hereinabove, so that their contact ends are disposed in a manner suitable for making contact with the bond pads of a semiconductor device having its bond pads arranged along its periphery.

Each contact element 500 (compare 100) has a base end 502 (compare 102) and a contact end 504 (compare 104), and are mounted to an electronic component such as a space transformer component (schematically illustrated by the dashed line 510) of a probe card assembly. The contact ends 504 are arranged close to one another, in a pattern mirroring that of the bond pads 522 (illustrated schematically by circles) of an electronic component (schematically illustrated by the dashed line 520) such as a semiconductor device. The spring contact elements 500 "fan-out" from their contact ends 504, so that their base ends 502 are disposed at a greater pitch (spacing from one another) than their contact ends 504.

**Figure 6** illustrates another application wherein a plurality of spring contact elements 600 such as those described hereinabove are arranged on a substrate such as a space transformer, and affixed thereto in the manner described hereinabove, so that their contact ends are disposed in a manner suitable for making contact with the bond pads of a semiconductor device having its bond pads arranged in a row along a centerline thereof.

Each spring contact element (compare 100), generally denoted by the reference numeral 600, has a base end 602 (compare 102) and a contact end 604 (compare 104), and are mounted to an electronic component such as a space transformer component (schematically illustrated by the dashed line 610) of a probe card assembly (not shown). The contact ends 604 are arranged close to one another, in a pattern mirroring that of the bond pads 622 (illustrated schematically by circles) of an electronic component (schematically illustrated by the dashed line 620) such as a semiconductor device. The spring contact elements 600 are arranged in the following sequence:
- a first spring contact element 600a is relatively short (e.g., has a length of 1.5 mm (60 mils)), and is disposed to extend towards a one side (right, as viewed) of the electronic component 620;
- a second spring contact element 600b, adjacent the first spring contact element 600a, is also relatively short (e.g., has a length of 1.5 mm (60 mils)), and is disposed to extend towards an opposite side (left, as viewed) of the electronic component 620;
- a third spring contact element 600c, adjacent the second spring contact element 600b, is relatively long (e.g., has a length of 2.0 mm (80 mils) ), and is disposed to extend towards the one side (right, as viewed) of the electronic component 620; and
- a fourth spring contact element 600d, adjacent the third spring contact element 600c, is also relatively long (e.g., has a length of 2.0mm (80 mils)), and is disposed to extend towards the opposite side (left, as viewed) of the electronic component 620. In this manner, the contact ends 604 are disposed at a fine-pitch commensurate with that of the bond pads 622, and the base ends 602 are disposed at a significantly greater pitch from one another.

The showing of only two different-length contact structures is merely exemplary and it should be understood that it is within the scope of this invention that a plurality of spring contact elements having more than two different lengths can be disposed on a common substrate. The showing of only two different-length contact structures is merely exemplary.

It is within the scope of this invention that the techniques illustrated in **Figures 5 and 6** may be used to generate a plurality of probes (spring contact elements) in any arrangement required for probing of either peripheral or lead-on-center (LOC) devices.

### ADDITIONAL FEATURES AND EMBODIMENTS

In cases where there are a plurality of spring contact elements mounted to a substrate and they are of different lengths (see, e.g., **Figure 6**), and assuming that the cross-sections and metallurgy of the spring contact elements are the same as one another, the different length spring contact elements will evidently exhibit different reactive forces (spring constants, k).
It is therefore within the scope of this invention that the spring constants of a plurality of spring elements exhibiting different spring constants can be adjusted (tailored), on an individual basis, to make them more uniform with one another.

**Figure 7A** illustrates a technique for tailoring spring constant. In this example, a spring contact element 700 (compare 450) is mounted by its base end 702 (compare 452) to an electronic component 710 (compare 444). A trench 712 (compare 442) is formed in the surface of the electronic component 710 and extends from under the contact end 704 (compare 454) of the spring contact structure 700, along the body portion 706 (compare 456) thereof, towards the base end 702 of the spring contact element 700 to a position (point) **"P"** which is located a prescribed, fixed distance, such as 60 mils from the contact end 704. When a force is applied downwards to the contact end 704, the entire spring contact element 700 will bend (deflect) until the body portion 706 contacts the end of the trench 712 at the point **"P",** whereupon only the outermost portion (from the point **"P"** to the end 704) of the spring contact element is permitted to deflect. The outermost portion of the spring contact element has an 'effective' length of **"L1".** The outermost portion of the spring contact element has an 'effective' length of **"L1".** In this manner, the reaction to applied contact forces can be made uniform among spring contact elements of various lengths (so long as the point **"P"** falls somewhere within the central body portion of the spring contact element).

**Figure 7B** illustrates another technique for tailoring spring constant. In this example, a spring contact element 720 (compare 450) is mounted by its base end 702 (compare 452) to an electronic component 710 (compare 444). A structure 732 (compare 712) is formed on the surface of the electronic component 730 (compare 710) at a location between the base end 722 of the spring contact structure 720, between the surface of the electronic component 730
and the central body portion 726 (compare 706) of the spring contact element 720 and extends along the body portion 726 (compare 706) thereof, towards the contact end 724 of the spring contact element 720 to a position (point) "P" which is located a prescribed, fixed distance, such as the aforementioned (with respect to **Figure 7A** prescribed distance, from the contact end 724. The structure is suitably a bead of any hard material, such as glass or a pre-cut ceramic ring, disposed on the surface of the electronic component 730. When a force is applied downwards to the contact end 724, only the outermost portion (from the point "**P**" to the end 724) of the spring contact element is permitted to deflect. As in the previous embodiment, the reactions to applied contact forces can be made uniform among spring contact elements of various lengths.

**Figure 7C** illustrates yet another technique for tailoring spring constant. In this example, a spring contact element 740 (compare 720) is mounted by its base end 742 (compare 722) to an electronic component 750 (compare 730). An encapsulating structure 752 (compare 732) is formed on the surface of the electronic component 750 in a manner similar to the structure 732 of the previous embodiment. However, in this case, the structure 752 fully encapsulates the base end 742 of the spring contact structure 740 and extends along the body portion 746 (compare 726) thereof, towards the contact end 744 thereof, to a position (point) **"P"** which is located a prescribed, fixed distance, such as the aforementioned (with respect to **Figure 7B** prescribed distance, from the contact end 744. The outermost portion of the spring contact element has an 'effective' length of **"L1".** As in the previous embodiment, when a force is applied downwards to the contact end 744, only the outermost portion (from the point **"P"** to the end 744) of the spring contact element is permitted to deflect. As in the previous embodiment, the reactions to applied contact forces can be made uniform among spring contact elements of various lengths.

**Figure 7D** illustrates yet another technique for tailoring spring constant. In this example, a spring contact element 760 (compare 740) is mounted by its base end 762 (compare 742) to an electronic component 770 (compare 750). In this example, the body portion 766 is formed with a "kink" 772 at a position (point) **"P"** which is located a prescribed, fixed distance, such as the aforementioned (with respect to **Figure 7C** prescribed distance, from the contact end 764. The outermost portion of the spring contact element has an 'effective' length of "**L1**". As in the previous embodiment, when a force is applied downwards to the contact end 744, only the outermost portion (from the point "**P**" to the end 744) of the spring contact element is permitted to deflect. (The kink 772 can be sized and shaped so that the entire contact structure deflects slightly before the kink 772 contacts the surface of the component 770, after which only the outermost portion of the spring element will continue to deflect.) As in the previous embodiment, the reactions to applied contact forces can be made uniform among spring contact elements of various lengths.

It is within the scope of this invention that other techniques can be employed to "uniformize" the spring constants among contact elements having different overall lengths ("L"). For example, their widths and or "α" taper can be different from one another to achieve this desired result.

### ALTERNATE EMBODIMENT

The spring contact elements illustrated and described hereinabove have been elongate and linear (disposed along the y-axis) , generally best suited to accommodate movement (deflection) in the z-axis (i.e., normal to the component or substrate to which they are mounted).

It is within the scope of this invention that additional "dimensionality" and commensurate additional freedom of movement be incorporated into the resulting spring contact element.

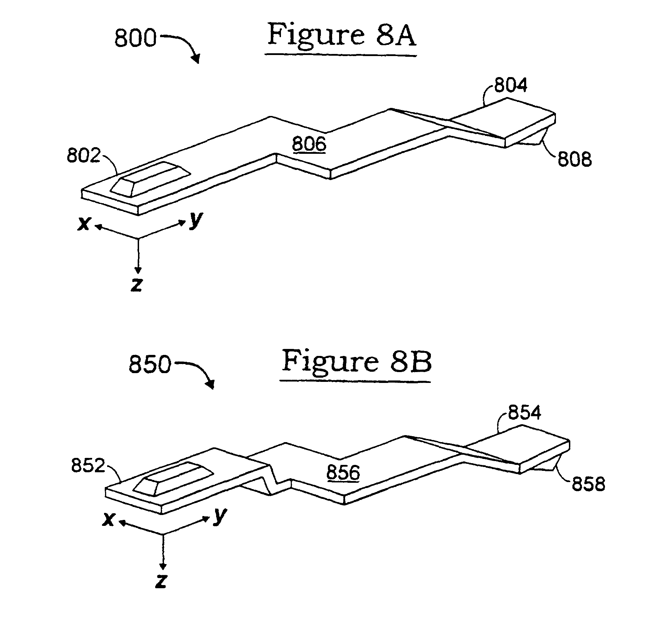

**Figure 8A** illustrates a spring contact element 800 that has been fabricated according to the techniques set forth hereinabove, with the exception (noticeable difference) that the central body portion 806 (compare 106) of the contact element is not straight, Although it may still lay in a plane (e.g., the x-y plane), it is illustrated as jogging along the x-axis while traversing the y-axis, in which case the base end 802 (compare 102) will have a different x-coordinate than the contact end 804 (compare 104) or the contact feature 808 (compare 108) disposed at the contact end 804.

**Figure 8B** illustrates a spring contact element 850 that is similar in many respects to the spring contact element 800 of **Figure 8A**, with the exception that there is a step between the central body portion 856 (compare 806) and the base portion 852 (compare 802) in addition to the step between the central portion 856 and the contact end portion 854 (compare 804). The contact element 850 is illustrated with a contact feature 858 (compare 808) at its contact end 854.

### CONTROLLED IMPEDANCE

For use in probing semiconductor devices, particularly at speed testing, it is advantageous that the spring contact elements have controlled impedance.

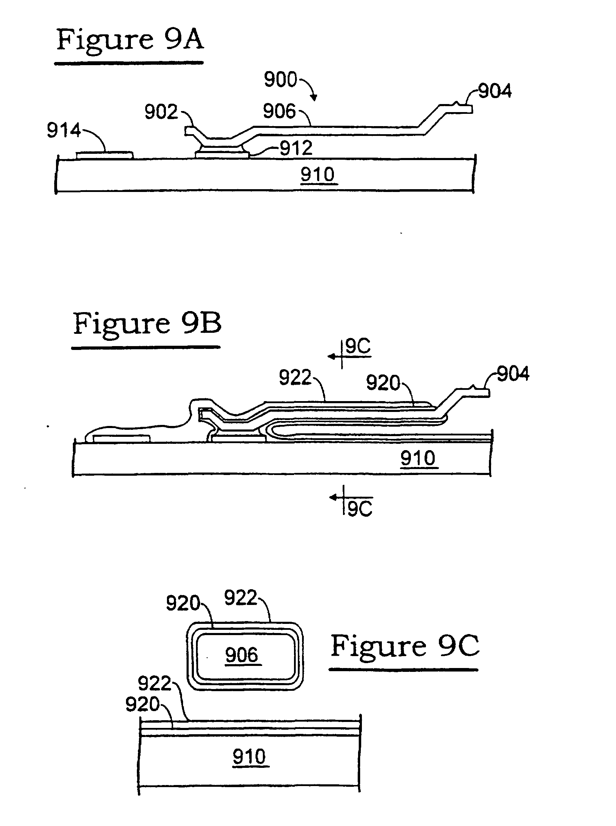

**Figures 9A-9C** illustrate a technique 900 for achieving controlled impedance in a spring contact element, according to the invention.

In a first step, best viewed in **Figure 9A**, a spring contact element 900 (compare 700) is mounted by its base end 902 (compare 702) to a terminal 912 of an electronic component 910 (compare 710) such as a space transformer component of a probe card assembly. The contact tip end 904 (compare 704) is elevated above the surface of the component 910 and is illustrated as having a contact feature. The spring contact structure has a central body portion 906 (compare 706) between its base and tip ends.

In a next step, best viewed in **Figure 9B,** the tip end 904 of the spring contact element is masked (not shown), and a suitable thin (e.g., 1-10 µm) insulating layer 920, such as parylene, is deposited, such as by vapor deposition, onto all but the tip end 904 of the spring contact element, and adjacent surface of the electronic component.

In a next step, best viewed in **Figure 9B,** while the tip end 904 of the spring contact element is still masked (not shown), a suitable thin (e.g., less than 0.25 mm) layer 922 of conductive material, such as any of the conductive metal material described herein, is deposited, such as by sputtering, onto all but the tip end 904 of the spring contact element, and adjacent surface of the electronic component. Finally, the tip end 904 is unmasked. This results in the central body portion 906 of the spring contact element being enveloped by a conductive layer 922, with an insulating layer 920 therebetween.

The conductive layer 922 is suitably connected to ground to function as a ground plane and control the impedance of the resulting spring contact element. For example, as best viewed in **Figure 9B**, the component 910 is provided with a second terminal 914 which is electrical ground. This terminal 914 is suitably masked along with the tip end 904 of the spring contact element prior to applying the insulating layer 920, so that the subsequent conductive layer 922 will also deposit thereon and be connected thereto.

Evidently, this thicknesses of the layers 920 and 922 need only be sufficient to be continuous, and to provide the sought after controlled impedance, and should not be so thick as to interfere with the mechanical operation of the spring contact element. The representations in **Figures 9B and 9C** are not drawn to scale.

Although the invention has been illustrated and described in detail in the drawings and foregoing description, the same is to be considered as illustrative and not restrictive in character - it being understood that only preferred embodiments have been shown and described, and that all changes and modifications that come within the spirit of the invention are desired to be protected. Undoubtedly, many other "variations" on the "themes" set forth hereinabove will occur to one having ordinary skill in the art to which the present invention most nearly pertains, and such variations are intended to be within the scope of the invention, as disclosed herein.

For example, the resulting spring contact elements may be heat-treated to enhance their mechanical characteristics, either while they are resident upon the sacrificial substrate or after they are mounted to another substrate or an electronic component. Also, any heat incident to mounting (e.g., by brazing) the spring contact elements to a component can advantageously be employed to "heat treat" the material of the spring contact element.

For example, a comparable spring contact element could be fabricated without etching into the sacrificial substrate, by disposing multiple layers of photoresist (masking material) onto a substrate, forming openings therein, seeding the opening for electroplating or the like, building up a metallic mass within the opening, and removing the photoresist. Such a technique would be particularly well suited to fabricating spring contact elements directly upon active semiconductor devices.

For example, it is within the scope of this invention that the contact structure can be fabricated on or attached to active semiconductor devices.

## Claims

1. Electronic interconnection apparatus, comprising:
a sacrificial substrate (202) comprising a plurality of trenches (220, 230), each trench comprising at least two contiguous subtrenches, each subtrench being at a different depth in said sacrificial substrate (202); and
a plurality of spring contact elements residing upon the sacrificial substrate (202) in said trenches (220, 230), wherein each spring contact element is elongate, and has a contact end portion (274) that is deeper in the surface of the sacrificial substrate (202) than a central body portion (276) of the contact element, thereby forming a first step between the contact end portion (274) and the central body portion (276);
wherein, in use, the spring contact elements can be mounted, en masse, to terminals of an electronic component.

2. Electronic interconnection apparatus, according to claim 1, wherein:
the sacrificial substrate (202) is a material that matches the coefficient of thermal expansion of silicon.

3. Electronic interconnection apparatus, according to claim 1, wherein:
the sacrificial substrate (202) is a material selected from the group consisting of silicon, aluminum, copper, ceramic, copper-invar-copper and aluminum-alumina-aluminum.

4. Electronic interconnection apparatus, according to claim 1, further comprising:
a release mechanism incorporated into the sacrificial substrate (202) which, in use, permits the sacrificial substrate to be removed after the spring contact elements are mounted to the terminals of the electronic component.

5. Method of mounting a plurality of spring contact elements to terminals of an electronic component, comprising:
fabricating a plurality of spring contact elements (270) in a plurality of trenches (220, 230) in a sacrificial substrate (202), wherein each trench comprises at least two contiguous subtrenches formed in the surface of the sacrificial substrate, a first one of the two subtrenches being at a first depth, a second one of the two subtrenches being at a second depth which is deeper than the first depth so that the contact element has at least one step;
subsequently, while the spring contact elements (270) are resident on the sacrificial substrate (202), mounting the spring contact elements to terminals of an electronic component; and
after the spring contact elements (270) are mounted to the terminals of the electronic component (408), removing the sacrificial substrate (202).

6. Method, according to claim 5 wherein:
the electronic component (408) is a space transformer.

7. A method of making a plurality of spring contact elements (270) which are supported in a predefined spatial relationship with one another, comprising:
defining a plurality of trenches (220, 230) in a surface of a sacrificial substrate (202);
depositing at least one layer of a metallic material into the trenches (220, 230), the metallic material in each trench representing a one of the plurality of spring contact elements (270);
wherein each spring contact element (270) is elongate, and is formed to have a contact end portion (274) that is deeper in the surface of the sacrificial substrate (202) than a central body portion (276) of the contact element, thereby forming a first step between the contact end portion and the central body portion,
wherein each trench (220, 230) comprises at least two contiguous subtrenches formed in the surface of the sacrificial substrate (202), a first one of the two subtrenches being at a first depth, a second one of the two subtrenches being at a second depth which is deeper than the first depth so that the resulting contact element has at least one step.

8. A method, according to claim 7, further comprising:
prior to depositing the at least one layer of metallic material, forming a depression (240) adjacent an end of the trench.

9. A method, according to claim 7, further comprising:
after making the spring contact elements (270) on the sacrificial substrate (202), mounting them to an electronic component (408), then removing the sacrificial substrate (202).

10. A method of mounting a plurality of spring contact elements (270) to a microelectronic component (408), comprising:
providing a plurality of elongate spring contact elements (270) formed in a plurality of trenches (220, 230) in a sacrificial substrate (202), each trench comprising at least two contiguous subtrenches each at a different depth in said sacrificial substrate, each spring contact element (270) having a base end (272), a contact end (274), and a central body portion (276) therebetween, wherein each said spring contact element has at least one step; and
mounting the base ends (272) of the spring contact elements to corresponding terminals on an electronic component (408), the contact ends (274) of the contact elements (270) extending above the surface of the electronic component.

11. Method, according to claim 10, wherein:
the electronic component (408) is a space transformer of a probe card assembly.

12. Method, according to claim 10, wherein:
the electronic component is a semiconductor device.

13. Method of forming microelectronic spring contact elements on a silicon substrate (202), comprising:
providing a blanket layer (204) of silicon nitride on a surface of a silicon substrate;
creating a plurality of openings (210) through the silicon nitride layer, thereby exposing the surface of the silicon substrate;
etching the silicon substrate within the openings (210) to form a corresponding plurality of first trenches (220), each extending to a first depth below the surface of the silicon substrate;
masking a portion of the first trenches (220);
etching the silicon substrate (202) within an unmasked portion of the first trenches (220) to form a corresponding plurality of second trenches (230) each extending to a second depth, greater than the first depth, below the surface of the silicon substrate;
depositing metallic material (256) into the first and second trenches (220, 230), the metallic material deposited into each first trench and corresponding second trench serving as one of a plurality of resulting microelectronic spring contact elements.

14. Method, according to claim 13, further comprising:
when depositing the metallic material (256) into the first and second trenches (220, 230), depositing the metallic material onto a portion of the surface of the silicon substrate which is adjacent to and contiguous with the first trenches.

15. Method, according to claim 14, further comprising:
prior to depositing the metallic material (256), depositing a release layer (252) into the first and second trenches (220, 230) and contiguous adjacent portion of the silicon substrate (202), said release layer adapted in use to permit the resulting microelectronic spring contact elements (270) to be removed from the silicon substrate.

## Patentansprüche

1. Elektronische Verbindungseinrichtung mit:
einem Opfersubstrat (202), das eine Vielzahl von Gräben (220, 230) aufweist, wobei jeder Graben zumindest zwei angrenzende Untergräben aufweist, wobei jeder Untergraben sich in einer unterschiedlichen Tiefe in dem Opfersubstrat (202) befindet; und
einer Vielzahl von Federkontaktelementen, die sich auf dem Opfersubstrat (202) in den Gräben (220, 230) befinden, wobei jedes Federkontaktelement länglich ist und einen Kontaktendbereich (274) aufweist, der sich tiefer in der Oberfläche des Opfersubstrats (202) befindet als ein mittlerer Rumpfbereich (276) des Federkontaktelements, und **dadurch** eine erste Stufe zwischen dem Kontaktendbereich (274) und dem mittleren Rumpfbereich (276) ausgebildet wird;
wobei die Federkontaktelemente bei Benutzung zusammen an Anschlussstellen eines elektronischen Bauteils befestigt werden können.

2. Elektronische Verbindungseinrichtung nach Anspruch 1, wobei:
das Opfersubstrat (202) ein Material ist, das dem thermischen Ausdehnungskoeffizienten von Silizium entspricht.

3. Elektronische Verbindungseinrichtung nach Anspruch 1, wobei:
das Opfersubstrat (202) ein Material ist, das ausgewählt ist aus einer Gruppe bestehend aus Silizium, Aluminium, Kupfer, Keramik, Kupfer-Invar-Kupfer und Aluminium-Aluminiumoxid-Aluminium.

4. Elektronische Verbindungseinrichtung nach Anspruch 1, die ferner aufweist:
einen in das Opfersubstrat (202) eingebauten Lösemechanismus, der es bei Verwendung erlaubt, das Opfersubstrat zu entfernen, nachdem die Federkontaktelemente an den Anschlussstellen des elektronischen Bauteils befestigt sind.

5. Verfahren zum Befestigen einer Vielzahl von Federkontaktelementen an Anschlussstellen eines elektronischen Bauteils, das aufweist:
Ausbilden einer Vielzahl von Federkontaktelementen (270) in einer Vielzahl von Gräben (220, 230) in einem Opfersubstrat (202), wobei jeder Graben zumindest zwei angrenzende Untergräben aufweist, die in der Oberfläche des Opfersubstrats ausgebildet sind, wobei ein Erster der beiden Untergräben sich in einer erste Tiefe befindet, und ein Zweiter der beiden Untergräben sich in einer zweiten Tiefe befindet, die größer ist als die erste Tiefe, so dass das Federkontaktelement (270) zumindest eine Stufe aufweist;
anschließend, während die Federkontaktelemente (270) sich auf dem Opfersubstrat befinden, Befestigen des Federkontaktelements (270) an Anschlussstellen eines elektronischen Bauteils; und
nachdem die Federkontaktelemente (270) an den Anschlussstellen eines elektronischen Bauteils (408) befestigt sind, Entfernen des Opfersubstrats (202).

6. Verfahren nach Anspruch 5, wobei:
das elektronische Bauteil (408) ein Raum-Transformator ist.

7. Verfahren zum Ausbilden einer Vielzahl von Federkontaktelementen (270), die in einem vorherdefinierten räumlichen Verhältnis zueinander gehalten werden, das aufweist:
Definieren einer Vielzahl von Gräben (220, 230) in einer Oberfläche eines Opfersubstrats (202);
Abscheiden von zumindest einer Schicht eines metallischen Materials in die Gräben (220, 230) hinein, wobei das metallische Material in jedem Graben jeweils eines der Vielzahl der Federkontaktelemente (270) darstellt;
wobei jedes Federkontaktelement (270) länglich ist und so ausgebildet, dass es einen Kontaktendbereich (274) aufweist, der sich tiefer in der Oberfläche des Opfersubstrats befindet als ein mittlerer Rumpfbereich (276) des Federkontaktelements, und **dadurch** eine erste Stufe zwischen dem Kontaktendbereich und dem mittleren Rumpfbereich ausbildet;
wobei jeder Graben (220, 230) zumindest zwei in der Oberfläche des Opfersubstrats (202) ausgebildete, benachbarte Untergräben aufweist, wobei ein Erster der beiden Untergräben sich in einer ersten Tiefe befindet, ein Zweiter der beiden Untergräben sich in einer zweiten Tiefe befindet, die größer ist als die erste Tiefe, so dass das resultierende Kontaktelement zumindest eine Stufe aufweist.

8. Ein Verfahren nach Anspruch 7, bei dem man:
vor dem Abscheiden der zumindest einen Schicht aus metallischem Material eine Vertiefung (240) angrenzend an ein Ende des Grabens ausbildet.

9. Verfahren nach Anspruch 7, bei dem man:
nach dem Ausbilden der Federkontaktelemente (270) auf dem Opfersubstrat (202) dieselben an einem elektronischen Bauteil befestigt und danach das Opfersubstrat entfernt.

10. Verfahren zum Befestigen einer Vielzahl von Federkontaktelementen (270) an einem mikroelektronischen Bauteil (408), das aufweist:
Bereitstellen einer in einer Vielzahl von Gräben (220, 230) in einem Opfersubstrat (202) ausgebildeten Vielzahl von länglichen Federkontaktelementen (270), wobei jeder Graben zumindest zwei angrenzende Untergräben in dem Opfersubstrat in jeweils unterschiedlicher Tiefe aufweist, wobei jedes Federkontaktelement (270) ein Basisende (272), ein Kontaktende (274) und dazwischen einen mittleren Rumpfbereich (276) aufweist, wobei jedes Federkontaktelement zumindest eine Stufe aufweist; und
Befestigen der Basisenden (272) der Federkontaktelemente an entsprechenden Kontaktstellen auf einem elektronischen Bauteil (408), wobei die Kontaktenden (274) der Kontaktelemente (270) sich über die Oberfläche des elektronischen Bauteils erstreckten.

11. Verfahren nach Anspruch 10, wobei:
das elektronische Bauteil (408) ein Raum-Transformator einer Prüfkartenanordnung ist.

12. Verfahren nach Anspruch 10, wobei:
das elektronische Bauteil ein Halbleiterbauteil ist.

13. verfahren zum Ausbilden mikroelektronischer Federkontaktelemente auf einem Siliziumsubstrat (202), das aufweist:
Bereitstellen einer Deckschicht (204) aus Siliziumnitrid auf einer Oberfläche eines Siliziumsubstrats;
Erzeugen einer Vielzahl von Öffnungen (210) durch die Siliziumnitridschicht, und **dadurch** Bloßlegen der Oberfläche des Siliziumsubstrats;
Ätzen des Siliziumsubstrats innerhalb der Öffnungen (210), um eine entsprechende Vielzahl von ersten Gräben (220) auszubilden, wobei sich jeder zu einer ersten Tiefe unter der Oberfläche des Siliziumsubstrats erstreckt;
Maskieren eines Teilbereichs der ersten Gräben (220);
Ätzen des Siliziumsubstrats (202) innerhalb eines unmaskierten Teilbereichs der ersten Gräben (220), um eine Vielzahl von zweiten Gräben (230) auszubilden, die sich jeweils in einer zweite Tiefe unter der Oberfläche des Siliziumsubstrats befinden, die größer ist als die erste Tiefe, erstrecken;
Abscheiden von metallischem Material (256) in die ersten und zweiten Gräben (220, 230) hinein, wobei das metallische Material, das in dem ersten Graben und dem entsprechenden zweiten Graben aufgebracht ist, als eines der Vielzahl von resultierenden mikroelektronischen Kontaktelementen dient.

14. Verfahren nach Anspruch 13, bei dem man:
beim Abscheiden des metallischen Materials (256) in die ersten und zweiten Gräben (220, 230) das metallische Material auf einen Bereich der Oberfläche des Siliziumsubstrats aufbringt, der angrenzend an und benachbart mit den ersten Gräben ist.

15. Verfahren nach Anspruch 14, bei dem man:
vor dem Abscheiden des metallischen Materials (256) eine Lösungsschicht (252) in die ersten und zweiten Gräben (220, 230) und den benachbarten, angrenzenden Bereich des Siliziumsubstrats (202) hinein abscheidet, wobei die Lösungsschicht so ausgebildet ist, dass sie bei Verwendung erlaubt, die resultierenden mikroelektronischen Federkontaktelemente (270) vom Siliziumsubstrat zu entfernen.

## Revendications

1. Dispositif d'interconnexion électronique, comprenant :
un substrat sacrificiel (202) comprenant une pluralité de tranchées (220, 230), chaque tranchée comprenant au moins deux sous-tranchées contiguës, chaque sous-tranchée étant à une profondeur différente dans ledit substrat sacrificiel (202), et
une pluralité d'éléments de contact à ressort résidant sur le substrat sacrificiel (202) dans lesdites tranchées (220, 230), chaque élément de contact à ressort étant allongé et présentant une partie d'extrémité de contact (274) qui est plus profonde, dans la surface du substrat sacrificiel (202), qu'une partie de corps centrale (276) de l'élément de contact, en formant ainsi un premier échelon entre la partie d'extrémité de contact (274) et la partie de corps centrale (276),
dans lequel, en utilisation, les éléments de contact à ressort peuvent être montés, ensemble ou globalement, sur les bornes d'un composant électronique.

2. Dispositif d'interconnexion électronique selon la revendication 1, dans lequel:
le substrat sacrificiel (202) est un matériau qui est adapté au coefficient de dilatation thermique du silicium.

3. Dispositif d'interconnexion électronique selon la revendication 1, dans lequel:
le substrat sacrificiel (202) est un matériau sélectionné parmi le groupe constitué du silicium, de l'aluminium, du cuivre, de la céramique, du cuivre-invar-cuivre et de l'aluminium-alumine-aluminium.

4. Dispositif d'interconnexion électronique selon la revendication 1, comprenant en outre :
un mécanisme de libération incorporé dans le substrat sacrificiel (202) qui, en utilisation, permet que l'on enlève le substrat sacrificiel après que les éléments de contact à ressort ont été montés sur les bornes du composant électronique.

5. Procédé de montage d'une pluralité d'éléments de contact à ressort sur les bornes d'un composant électronique, comprenant :
la fabrication d'une pluralité d'éléments de contact à ressort (270) dans une pluralité de tranchées (220, 230) dans un substrat sacrificiel (202), où chaque tranchée comprend au moins deux sous-tranchées contiguës formées dans la surface du substrat sacrificiel, une première des deux sous-tranchées étant à une première profondeur, une seconde des deux sous-tranchées étant à une seconde profondeur qui est plus profonde que la première profondeur, de sorte que l'élément de contact présente au moins un échelon,
ensuite, alors que les éléments de contact à ressort (270) sont situés sur le substrat sacrificiel (202), le montage des éléments de contact à ressort sur les bornes d'un composant électronique, et
après que les éléments de contact à ressort (270) ont été montés sur les bornes du composant électronique (408), l'enlèvement du substrat sacrificiel (202)

6. Procédé selon la revendication 5, dans lequel :
le composant électronique (408) est un adaptateur d'espacement.

7. Procédé de réalisation d'une pluralité d'éléments de contact à ressort (270) qui sont supportés dans une relation dans l'espace prédéfinie les uns avec les autres, comprenant les étapes consistant à :
définir une pluralité de tranchées (220, 230) dans une surface d'un substrat sacrificiel (202),
déposer au moins une couche d'un matériau métallique dans les tranchées (220, 230), le matériau métallique dans chaque tranchée représentant un élément parmi la pluralité d'éléments de contact à ressort (270),
dans lequel chaque élément de contact à ressort (270) est allongé, et est formé de manière à présenter une partie d'extrémité de contact (275) qui est plus profonde dans la surface du substrat sacrificiel (202), qu'une partie de corps centrale (276) de l'élément de contact, en formant ainsi un premier échelon entre la partie d'extrémité de contact et la partie de corps centrale,
dans lequel chaque tranchée (220, 230) comprend au moins deux sous-tranchées contiguës, formées dans la surface du substrat sacrificiel (202), une première des deux sous-tranchées étant à une première profondeur, une seconde des deux sous-tranchées étant à une seconde profondeur, qui est plus profonde que la première profondeur, de sorte que l'élément de contact résultant présente au moins un échelon.

8. Procédé selon la revendication 7, comprenant en outre l'étape consistant à:
former un creux (240) adjacent à une extrémité de la tranchée avant de déposer la au moins une couche de matériau métallique.

9. Procédé selon la revendication 7, comprenant en outre l'étape consistant à :
après avoir réalisé les éléments de contact à ressort (270) sur le substrat sacrificiel (202), monter ceux-ci sur un composant électronique (408), puis enlever le substrat sacrificiel (202).

10. Procédé de montage d'une pluralité d'éléments de contact à ressort (270) sur un composant microélectronique (408), comprenant les étapes consistant à :
fournir une pluralité d'éléments de contact à ressort allongés (270) formés dans une pluralité de tranchées (220, 230) dans un substrat sacrificiel (202), chaque tranchée comprenant au moins deux sous-tranchées contiguës, chacune à une profondeur différente, dans ledit substrat sacrificiel, chaque élément de contact à ressort (270) présentant une extrémité de base (272), une extrémité de contact (274), et une partie de corps centrale (276) entre les deux, chaque élément de contact à ressort présentant au moins un échelon, et
monter les extrémités de base (272) des éléments de contact à ressort sur les bornes correspondantes sur un composant électronique (408), les extrémités de contact (274) des éléments de contact (270) s'étendant au-dessus de la surface du composant électronique.

11. Procédé selon la revendication 10, dans lequel :
le composant électronique (408) est un adaptateur d'espacement d'un ensemble de carte de sonde.

12. Procédé selon la revendication 10, dans lequel:
le composant électronique est un dispositif à semiconducteur.

13. Procédé de formation d'éléments de contact à ressort microélectroniques sur un substrat de silicium (202), comprenant les étapes consistant à :
fournir une couche de couverture (204) de nitrure de silicium sur une surface d'un substrat de silicium,
créer une pluralité d'ouvertures (210) au travers de la couche de nitrure de silicium, en exposant ainsi la surface du substrat de silicium,
graver le substrat de silicium à l'intérieur des ouvertures (210) afin de former une pluralité correspondante de premières tranchées (220), chacune s'étendant jusqu'à une première profondeur sous la surface du substrat de silicium,
masquer une partie des premières tranchées (220),
graver le substrat de silicium (202) dans une partie non masquée des premières tranchées (220) afin de former une pluralité correspondante de secondes tranchées (230) s'étendant chacune jusqu'à une seconde profondeur, supérieure à la première profondeur, sous la surface du substrat de silicium,
déposer un matériau métallique (256) dans les première et secondes tranchées (220, 230), le matériau métallique déposé dans chaque première tranchée et la seconde tranchée correspondante servant comme un élément d'une pluralité d'éléments de contact à ressort microélectroniques résultants.

14. Procédé selon la revendication 13, comprenant en outre l'étape consistant à :
lors du dépôt du matériau métallique (256) dans les premières et secondes tranchées (220, 230), déposer le matériau métallique sur une partie de la surface du substrat de silicium qui est adjacente aux premières tranchées et contiguë à celles-ci.

15. Procédé selon la revendication 14, comprenant en outre l'étape consistant à :
avant de déposer le matériau métallique (256), déposer une couche de libération (252) dans les premières et secondes tranchées (220, 230) et la partie adjacente contiguë du substrat de silicium (202), ladite couche de libération étant conçue, en utilisation, pour permettre aux éléments de contact à ressort microélectroniques résultants (270) d'être enlevés du substrat de silicium.
